# EUROPEAN PATENT SPECIFICATION

(11) **EP 0 434 234 B1**
(45) Date of publication and mention of the grant of the patent: **24.05.1995**
(21) Application number: 90312785.0
(22) Date of filing: 23.11.1990
(51) Int. Cl.: H01L 27/02, H01L 27/088, H01L 29/423

(54) **MOS devices having improved electrical match**
MOS-Bauteile mit einer verbesserten elektrischen Anpassung
Dispositifs MOS ayant une adaptation électrique améliorée

(30) Priority: 22.12.1989 US 456008
(43) Date of publication of application: 26.06.1991
(73) Proprietor: AT&T Corp., New York, NY 10013-2412 (US)
(72) Inventor: Gabara, Thaddeus John, Schnecksville, Pennsylvania 18078 (US); Metz, Peter C., Emmaus, Pennsylvania 18049 (US)
(74) Representative: Buckley, Christopher Simon Thirsk

(56) References cited:
- EP-A- 0 161 733
- EP-A- 0 323 158
- US-A- 4 757 029
- PATENT ABSTRACTS OF JAPAN vol. 8, no. 53 (E-231) 09 March 1984 & JP-A-58 207677
- PATENT ABSTRACTS OF JAPAN vol. 10, no. 356 (E-459)(2412) 29 November 1986 & JP-A-61 154156
- PATENT ABSTRACTS OF JAPAN vol. 10, no. 343 (E-456)(2399) 19 November 1986 & JP-A-61 147573
- PATENT ABSTRACTS OF JAPAN, vol. 5, no. 133, (E-071), 25 August 1981 & JP-A-56 069 865

## Description

This invention relates to integrated circuits.

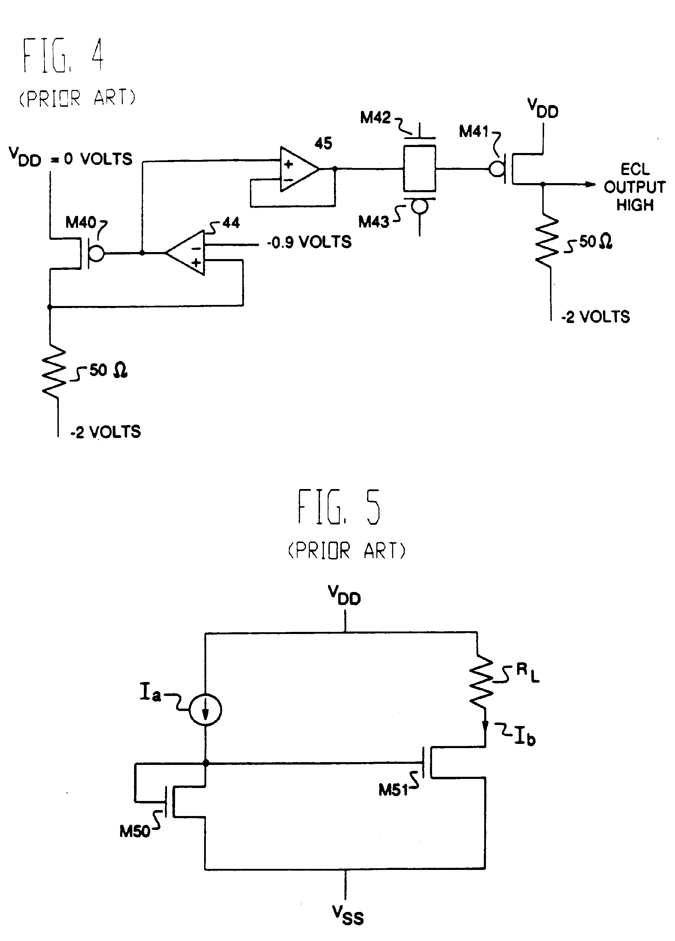

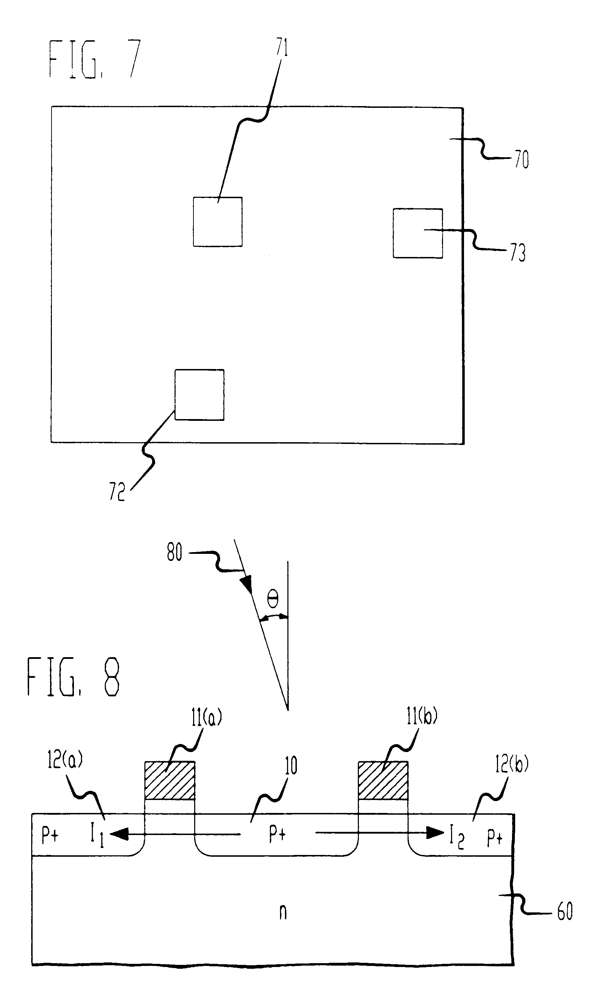

In certain integrated circuit applications, it is desirable to have two or more transistors with well-matched electrical characteristics. For example, in CMOS output buffers that provide ECL output levels (-0.9 to -1.7 volts), it is desirable to obtain a precise and well-controlled output level, in order to properly match the characteristics of the ECL bipolar devices. One type of ECL output buffer is shown in Fig. 4, wherein a reference MOS device M40 is provided, and the transistor M41 is used to set the level of the ECL "high" output voltage. Note that the gates of M40 and M41 are coupled together, by means of operational amplifiers 44, 45, and pass gate transistors M42, M43. It is desirable that the electrical characteristics of M40 and M41 be well- matched. (A comparable circuit may be used for setting the ECL "low" output voltage.) This type of output buffer is more fully described in U.S. patent application serial number 371356, filed June 26, 1989, (US-A-5,043,605) and co-assigned herewith.

In another example, Fig. 5 illustrates a current mirror, wherein the gate and drain of a reference transistor M50 are connected together, with a current source causing a channel current Ia to flow. A "mirror" transistor M51 has its gate connected to the gate of the reference transistor, and the channel current Ib flowing though load R_{L} will be equal, or proportional, to Ia, depending on the relative sizes of the transistors. To obtain precise control of Ib, the electrical characteristics (e.g., threshold and transconductance) of M51 should be the same as that of M50. More than one transistor can mirror the current in M50 in a similar manner. For an example of a current source having a current mirror, see US-A-4,645,948 co-assigned herewith. However, the "reference" transistors of these examples (e.g., M40, M50) may be located on the integrated circuit at significant distances from the other transistors that should be matched to them (e.g., M41, M51). In these applications, the gate-to-source voltages of the matched transistors are identical, or nearly so.

It is recognized in the art that the location of a transistor on an integrated circuit can affect its characteristics. For example, the gate oxide thickness can vary over the surface of the integrated circuit. This can produce differences in the channel current that flows for a given gate-to-source voltage from one transistor as compared to another. For this reason, circuit and layout techniques have been developed to compensate for the differing transistor characteristics. For example, the "common centroid" configuration utilizes a group of four transistors arranged at the corners of a rectangle, with the diagonal pairs being connected in parallel. This effectively creates two transistor pairs, which may be used to implement a current mirror. The processing variations that are a function of placement (i.e., along the x and y axes of the broad surface of the chip) then largely cancel out. This is because each pair includes a transistor having the same x-axis location as one transistor of the other pair, and the same y-axis location as the other transistor of the other pair, thereby averaging out variations that are solely a linear function of position.

In addition, there are some process variations that result from orientation effects. For example, the ion beam implantation of source/drain regions may create shadowing effects that affect transistor performance, by changing the threshold voltage. This is discussed by R.W. Gregor in "Some Consequences of Ion Beam Shadowing in CMOS Source/Drain Formation", IEEE Electron Device Letters, Vol. EDL-7, No. 12, pp.677-679 (1986). To negate such orientation-dependent effects, the prior art layout techniques required that matched transistors be oriented in the same direction, and with current flows in the same direction. However, such requirements limit design flexibility, and can complicate the layout process.

From JP-A-58 207 677 an integrated circuit is known which has paired transistors included in an amplifier. The gate electrodes of the paired transistors are U-shaped and have their segments arranged in parallel. Thus current components in both directions at the parallel parts of the U-shaped area cancel each other.

An integrated circuit having field effect transistors with gate electrodes shaped as a polygon having an even number of sides of equal length or as a circle is known from EP-A-0 161 733.

According to this invention there is provided an integrated circuit as claimed in claim 1. Dependent claims 2 to 7 specify advantageous embodiments.

The invention will now be described with reference to the accompanying drawings, in which:
Fig. 1 shows an embodiment of an MOS transistor, wherein the gate electrode forms a square;
Fig. 2 shows another embodiment of an MOS transistor, wherein the gate electrode forms concentric squares;
Fig. 3 shows a further embodiment of an MOS transistor, wherein the gate electrode forms a cross.
Fig. 4 shows an ECL output buffer that may advantageously use the invention;
Fig. 5 shows a current mirror that may advantageously use the invention;
Fig. 6 shows a cross-section view along line A′ -A′ of the embodiment of Fig. 1.
Fig. 7 shows a typical layout of matched transistors along the edges of an integrated circuit chip; and
Fig. 8 shows a cross-section view along line B′ -B′ of the embodiment of Fig. 1.

The present detailed description refers to an integrated circuit technique that allows for placement of matched transistors in any orientation while obtaining improved control of transistor characteristics. In the present technique, a MOS transistor is designed so that orientation effects cancel out This provides for improved ease of circuit layout, especially when the transistors are spaced apart at significant distances on an integrated circuit For example, referring to Fig. 7, the 90 degree rotational symmetry of the square-gate transistors described herein allows for placement of matched transistors (72, 73) in the I/O frame along different sides of an IC chip (70), as is typically the case for output buffers, without regards as to horizontal versus vertical transistor design. The reference transistor 71 to which the others are matched may be located either in the interior of the chip as shown, or along a side. This simplifies the design of integrated circuits, since a single transistor geometry may be used in all locations, without the possibility of introducing errors with regard to orientation.

As used herein, "matched" implies that in operation, it is desired to obtain either the same source-to-drain voltage across the transistors, or channel currents that are proportional to the sizes of the transistors, depending on the application. The matched transistors may be of equal or unequal sizes, providing for either the same or different channel currents, respectively.

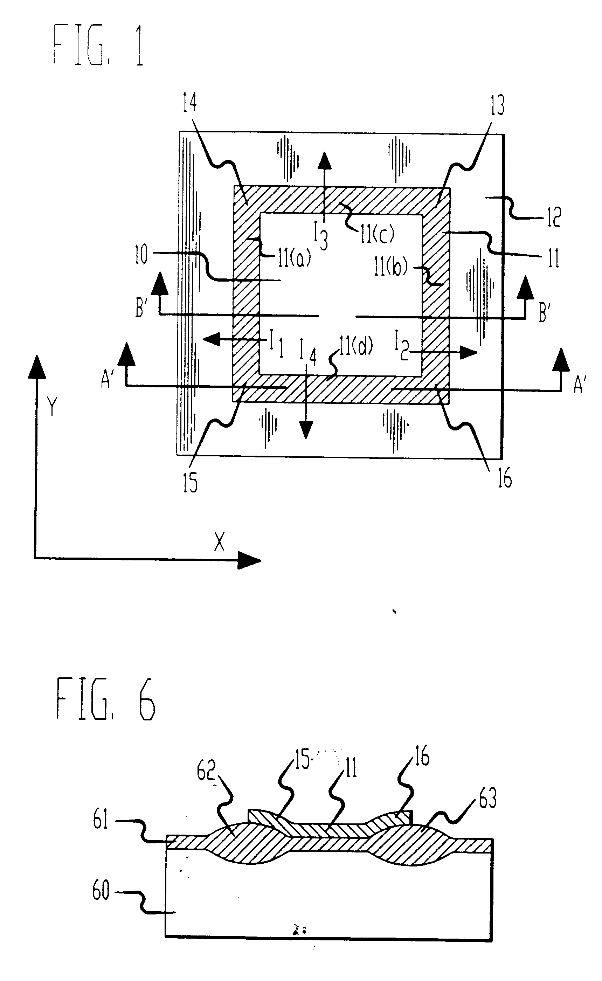

Referring to Fig. 1, an MOS transistor is shown in a top view, as formed in a semiconductor substrate. The transistor includes a doped source region 10, gate electrode 11 (overlying a gate dielectric), and doped drain region 12. In the illustrative embodiment, the source and drain regions are p+, with the gate overlying a n type region, so that a p-channel device is formed. The structure is arranged so that the channel current flowing between the source and drain regions comprises symmetrical horizontal and vertical components I1 ... I4. That is, the square gate structure provides a left-hand portion 11(a), right-hand portion 11(b), top portion 11(c), and bottom portion 11(d) as viewed. Portions 11(a) and 11(b) are parallel to the y-axis of the integrated circuit chip, whereas portions 11(c) and 11(d) are parallel to the x-axis, which is orthogonal to the y-axis. (The x-axis is typically the short axis of the chip, and the y-axis is typically the long axis.) The lengths of portion 11(a) ... 11(d) are essentially equal.

As a result of this layout, current I1 and current I2 are nominally equal in magnitude, and flow in opposite directions. Similarly, currents I3 and I4 are nominally equal and opposite. Therefore, the effect of process variations tend to be the same for all such square-gate transistors. For example, shadowing of the source/drain ion implant by the gate structure may occur if the ions are implanted at an angle off the vertical, as is frequently the case. Consider the case that the angle of implantation is slightly (e.g., 7 degrees) to the left of the vertical as viewed in Fig. 1. The gate shadowing will cause a slight variation in the values of I1 and I2 from the nominal design value, whereas I3 and I4 will be relatively unaffected. However, that variation in 11 and I2 will be substantially the same for all of the transistors on a given integrated circuit that are of the square-gate type shown in Fig. 1. Note that the square-gate transistors have 90 degree rotational symmetry.

The effect of ion beam shadowing may be seen more clearly in Fig. 8, which is a cross-section view taken along B′ - B′ of Fig. 1, and labelled correspondingly. The integrated circuit is formed in semiconductor body 60, and comprises source region 10, gate electrode 11, and drain region 12. In particular, drain regions 12(a) and 12(b), and gate electrodes 11(a) and 11(b) correspond to the left and right hand portions of these features as shown in Fig. 1, respectively. It can be seen that the dopant ions 80, implanted at an angle ϑ from the normal, will be shadowed by gate electrodes (11(a) and 11(b), as noted above. This may affect the currents I1 and I2, by causing a deviation from their nominal values, as discussed below.

The slight variations from nominal may have either the same, or opposite, signs, depending on the processing effects. For example, some processing effects may cause both I1 and I2 to increase slightly from the nominal. Alternately, other processing effects may cause I1 to increase slightly and I2 to decrease slightly from the nominal values. Furthermore, the magnitude of the variations may be different for I1 and I2. (Comparable statements may be made about I3 and I4). In any of these cases, the variations will tend to be the same for all such transistors on a given integrated circuit. Therefore, the circuit designer need not be concerned with respect to vertical or horizontal orientation of the square-gate transistors. That is in contrast to the case wherein the transistors have conventional gate structures, in which case the vertically-oriented transistors will be affected differently than the horizontally-oriented transistors.

For improved electrostatic discharge (ESD) protection, the gate conductor in the corner regions 13 ... 16 may be run over the field oxide region, rather than over the thin oxide layer that forms the gate dielectric. This is because a high electric field is produced by the sharp angles of the gate conductor at these points. This may be seen in the sectional view taken along A′ - A′ of the gate structure of Fig. 6, wherein the silicon substrate 60 has formed thereon a thin oxide layer 61 which serves as the gate dielectric. The relatively thicker field oxide regions (e.g., 62, 63) then serve to provide increased ESD breakdown protection at the corners (e.g., 15, 16). However, the increased ESD protection is not necessary in all designs, or all process technologies.

It is possible to increase the current-carrying capacity of the transistors by a concentric gate design. For example, referring to Fig. 2, an inner gate 201 controls the current flow from source 202 to drain regions 203,204, 205 and 206 (i.e., currents I1, I2, I3 and I4). In addition, outer gate 207 controls the current flow from source 208 to drain regions 203 ... 206 (i.e., currents I5, I6, I7 and I8). The inner and outer gates are connected together, as by conductors 209 ... 212, which are typically formed of the same conductive layer as gates 201 and 207 (e.g., polysilicon or polycide). As above, it is desirable that the corner regions (e.g., 213, 214) be placed over the field oxide regions for ESD protection. The conductors 209... 212 are then also conveniently run over the field oxide regions. To contact the gate, source, and drain regions, contact windows may be formed in an overlying dielectric, and aluminum (or other conductors) patterned to provide the required connections, according to principles well known in the art. Still more current capacity may be obtained by the use of two or more transistors that are formed adjacent one another and interconnected.

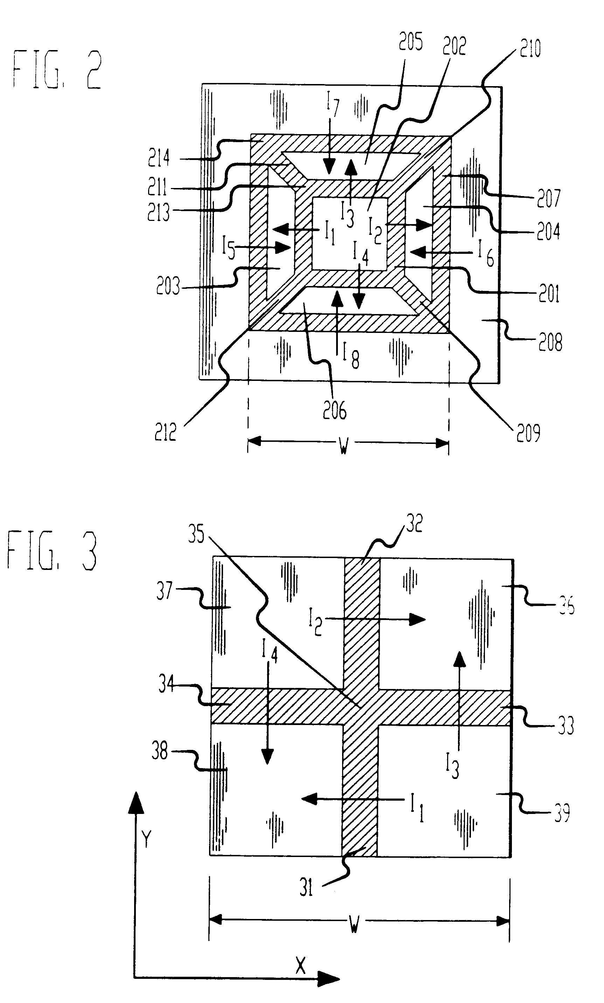

The foregoing has shown a square-gate transistor, which is a presently-preferred embodiment, being relatively compact and readily laid out on an integrated circuit. However, other embodiments are possible. For example, Fig. 3 shows the gate in the form of a cross. The gate conductor comprises vertical portions 31, 32 and horizontal portions 33,34. These gate portions control channel current components 11, I2, I3, and I4, respectively. Diagonally opposite doped regions 37 and 39 comprises the source, and doped regions 36 and 38 comprise the drain of the transistor. Note that as above, there are current components of nominally equal magnitude flowing in opposite directions along two orthogonal axes. As in the foregoing structures, it is desirable for the intersection region 35 of the gate electrode to be run over the relatively thick field oxide region, for improved ESD protection.

Still other gate geometries are possible, as with gates that encompass hexagonal or even higher-order polygons with an even number of sides. The sides of a given polygon are equal in length, thereby obtaining an equilateral, and hence symmetrical, structure. Note that to obtain matched transistors, the sides of the gate of one transistor are oriented parallel to the corresponding sides of the gate of the other transistor matched thereto. However, as with the squares, the sizes of the encompassed regions may be different, as to obtain current-scaled devices. In the limiting case, even gates that define circular-shaped source/drain regions are possible, and in fact may provide the best matched transistors. However, at present, the square-gate layout is preferable for ease of lithographic definition.

The above embodiments illustrate the current flows for p-channel transistors, with the flows for n-channel transistors being in the opposite directions. Also, the orientation of the gate portions parallel to the edges of a rectangular integrated circuit are typical for the layout of an integrated circuit chip, but not necessary, as long as the gate segments of the one matched transistor are parallel to those of the other matched transistor. The effect of ion implantation angle on the variation of the threshold voltage from the nominal value has been noted above. However, other orientation-dependent processing operations that cause a departure from nominal electrical characteristics can also be compensated.

Such operations could include, for example, etching or lithographic operations. Matched transistors are typically spaced apart at least 5 times the width of the gate "W", as defined in Figs. 2 and 3, and more typically at least 10 times "W". With present-day integrated circuit geometries, this is a typical spacing of at least 100 micrometers, and in many cases even more than 1 millimeter.

## Claims

1. An integrated circuit comprising field effect transistors (M40,M41;M50,M51) each having a doped source region (10) and a doped drain region (12) formed in a semiconductor substrate (60), with said source and drain region being separated by a channel region overlaid by a gate electrode (11), wherein at least a first and a second of said transistors are spaced apart from each other and have their gate electrodes coupled together, whereas the drain region of the first transistor is not connected to the drain region of the second transistor, and wherein further said first and second transistor obtain matched electrical characteristics due to the gate electrodes of the first and second transistor consisting of segments (11a,11b,11c,11d) which are mutually parallel to each other, and the gate electrodes having a shape selected from the group consisting of: a cross with axes of equal lengths; a circle, and a polygon having an even number of sides of equal length.

2. An integrated circuit as claimed in claim 1 wherein said shape is a square.

3. An integrated circuit as claimed in claim 1 wherein said first and second transistors are of equal size.

4. An integrated circuit as claimed in claim 1 wherein said first and second transistors are of unequal size.

5. An integrated circuit as claimed in claim 1 wherein said first and second transistors are spaced at least 100 micrometers apart.

6. An integrated circuit as claimed in claim 1 wherein said first and second transistors are spaced at least 1 millimeter apart.

7. An integrated circuit as claimed in any preceding claim wherein the first one of said matched transistors (72) is located along a given side of an integrated circuit chip (70), and the second one of said matched transistors (73) is located along another side of said integrated circuit chip.

## Patentansprüche

1. Integrierte Schaltung mit Feldeffekttransistoren (M40,M41; M50,M51), die jeweils ein dotiertes Sourcegebiet (10) und ein dotiertes Draingebiet (12) aufweisen, die in einem Halbleitersubstrat (60) gebildet sind, wobei besagtes Source- und Draingebiet durch ein von einer Gateelektrode (11) überlagertes Kanalgebiet getrennt sind, wobei mindestens ein erster und ein zweiter der besagten Transistoren voneinander beabstandet sind und mit ihren Gateelektroden zusammengekoppelt sind, während das Draingebiet des ersten Transistors nicht mit dem Draingebiet des zweiten Transistors verbunden ist, und wobei weiterhin der besagte erste und zweite Transistor übereinstimmende elektrische Eigenschaften erhalten, da die Gateelektroden des ersten und zweiten Transistors aus Segmenten (11a,11b,11c,11d) bestehen, die zueinander parallel liegen, und die Gateelektroden eine Form aufweisen, die aus der aus folgenden bestehenden Gruppe ausgewählt ist: einem Kreuz mit Achsen gleicher Länge; einem Kreis, und einem Vieleck mit einer geradzahligen Anzahl von Seiten gleicher Länge.

2. Integrierte Schaltung nach Anspruch 1, wobei die besagte Form ein Quadrat ist.

3. Integrierte Schaltung nach Anspruch 1, wobei der besagte erste und zweite Transistor von gleicher Größe sind.

4. Integrierte Schaltung nach Anspruch 1, wobei der besagte erste und zweite Transistor ungleicher Größe sind.

5. Integrierte Schaltung nach Anspruch 1, wobei der besagte erste und zweite Transistor um mindestens 100 Mikrometer voneinander beabstandet sind.

6. Integrierte Schaltung nach Anspruch 1, wobei der besagte erste und zweite Transistor um mindestens 1 Millimeter beabstandet sind.

7. Integrierte Schaltung nach einem der vorhergehenden Ansprüche, wobei der erste der besagten paarigen Transistoren (72) sich entlang einer gegebenen Seite eines integrierten Schaltungsbausteins (70) befindet und der zweite der besagten paarigen Transistoren (73) sich entlang einer anderen Seite des besagten integrierten Schaltungsbausteins befindet.

## Revendications

1. Circuit intégré comprenant des transistors à effet de champ (M40,M41;M50,M51) ayant chacun une zone source dopée (10) et une zone drain dopée (12) formées dans un substrat semi-conducteur (60), lesdites zones source et drain étant séparées par une zone canal recouverte par une électrode de grille (11), dans lequel au moins un premier et un second desdits transistors sont espacés l'un par rapport à l'autre et ont leurs électrodes de grille couplées ensemble, tandis que la zone drain du premier transistor n'est pas connectée à la zone drain du second transistor, et dans lequel des autres dits premier et second transistors obtiennent des caractéristiques électriques adaptées dues aux électrodes de grille des premier et second transistors consistant en segments (11a,11b,11c,11d) qui sont mutuellement parallèles les uns par rapport aux autres, et les électrodes de grille ont une forme sélectionnée dans un groupe composé de: une croix aux axes de longueurs égales; un cercle, et un polygone ayant un nombre égal de côtés de longueur égale.

2. Circuit intégré tel que revendiqué dans la revendication 1, dans lequel ladite forme est un carré.

3. Circuit intégré tel que revendiqué dans la revendication 1, dans lequel lesdits premier et second transistors sont de taille égale.

4. Circuit intégré tel que revendiqué dans la revendication 1, dans lequel lesdits premier et second transistors sont de taille inégale.

5. Circuit intégré tel que revendiqué dans la revendication 1, dans lequel lesdits premier et second transistors sont espacés d'au moins 100 micromètres.

6. Circuit intégré tel que revendiqué dans la revendication 1, dans lequel lesdits premier et second transistors sont espacés d'au moins 1 millimètre.

7. Circuit intégré tel que revendiqué dans l'une quelconque des revendications précédentes, dans lequel le premier desdits transistors adaptés (72) est situé sur un côté donné d'une puce de circuit intégré (70), et le second desdits transistors adaptés (73) est situé sur un autre côté de ladite puce de circuit intégré.
